(19) Europäisches Patentamt
European Patent Office
Office européen des brevets

(11) **EP 4 542 803 A1**

(12) **EUROPEAN PATENT APPLICATION**

(43) Date of publication:
**23.04.2025 Bulletin 2025/17**

(21) Application number: **23204584.9**

(22) Date of filing: **19.10.2023**

(51) International Patent Classification (IPC):
**H02H 3/42** *(2006.01)*    **G01R 31/08** *(2020.01)*
**H02H 7/26** *(2006.01)*

(52) Cooperative Patent Classification (CPC):
**H02H 3/425; G01R 31/08; G01R 31/085;**
**H02H 7/267**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Hitachi Energy Ltd**
**8050 Zürich (CH)**

(72) Inventors:
• **NAIDU, Obbalareddi Demudu**
  **560087 Karnataka (IN)**
• **GEORGE, Neethu**
  **560049 Karnataka (IN)**

(74) Representative: **Vossius & Partner**
**Patentanwälte Rechtsanwälte mbB**
**Siebertstraße 3**
**81675 München (DE)**

(54) **METHOD, DEVICE AND SYSTEM FOR DETERMINING A FAULT IN A DOUBLE-CIRCUIT LINE**

(57)    The present disclosure relates to a method for determining a fault in a double-circuit line comprising a first line and a second line. The method comprises calculating a first angle of a power at a beginning of a monitored line length of the first line, calculating a second angle of a power at an end of the monitored line length of the first line, performing an operation with the first angle and the second angle to calculate a first fault factor, and determining whether the fault is on the first or second line based on a polarity of the first fault factor. The disclosure further relates to a corresponding device and system.

```
┌─────────────────────────────────────────┐
│  S1 Acquire local voltage and current    │
│     measurements from line 1 and/or 2    │
└─────────────────────────────────────────┘
                    │
                    ▼
┌─────────────────────────────────────────┐
│  S2 Perform protection algorithm         │
└─────────────────────────────────────────┘
                    │
                    ▼
┌─────────────────────────────────────────┐
│  S3 Fault line and fault zone             │
│     identification,                       │
│     determination of fault location,      │
│     trip decision                         │
└─────────────────────────────────────────┘
```

Fig. 3

EP 4 542 803 A1

**Description**

The present disclosure relates to a method, device and system for determining a fault in a double-circuit line. In particular, the present disclosure relates to secure distance protection and accurate fault location for double-circuit lines connected to conventional and/or renewable energy sources.

Double-circuit lines are widely used on transmission systems due to their significant efficiency, reliability, economic and environmental advantages over single-circuit lines. For example, currently, more than 50% of the transmission line circuit length in India is constituted of 400 kV and 765 kV lines [1], of which a majority are double circuit lines. However, due to the mutual coupling effects between the two circuits, the transient signals induced on the two circuits due to a fault on one circuit are quite different from those encountered on a single-circuit line. This makes the protection of these lines more complicated.

Currently, the most commonly used protection techniques for double-circuit transmission lines are a separate current differential protection for each line together with a distance protection technique as backup [2]. The former one is a unit protection which is dependent on communication between the two terminals. A non-unit protection based only on local measurements, like distance protection, is further critical and necessary. However, distance protection faces several challenges when applied to lines in systems integrated with inverter-based renewable energy resources (IBR) [3]. Integration of utility-scale renewable plants at transmission levels is increasing exponentially and hence, single-ended protection (using only local measurements) of double circuit lines in transmission systems with renewable energy resources is a problem and need of the hour.

Several local measurement-based protection methods have been proposed for transmission lines connected to IBRs in recent literature. Various approaches, including fixed zone setting based, adaptive zone setting based, communication assisted, modified control-based and neural network-based solutions, have been explored.

Improved distance relaying techniques have been proposed in [4], [5] by calculating faulted section impedance to compensate for the effect of fault resistance in the presence of remote infeed. However, these either ignore the equivalent source impedance of each end of a protected line or consider them to be homogeneous to the line impedance. This is however not true for IBR-connected systems. Improved communication assisted tripping schemes are proposed in [6], [7] for the lines emanating from IBR. However, they have latency issues associated with protection decisions and there is no solution in case of communication failure. A control-based solution is provided in [8], which regulates the fault current angle from IBR imitating the characteristics of a synchronous generator. However, it is difficult to be generalised for different renewable plants with various control schemes.

Apparent impedance correction methods by estimation of the non-homogeneity angle introduced by IBRs is presented in [9], [10]. These methods are developed for terminals at which IBRs are connected, with the assumption that the remote end is connected to traditional generators only. These are not generic, i.e., not applicable for lines connected to traditional generator-based grid or for lines with IBRs connected at both ends. Additionally, these methods do not address the problem of mutual coupling in double-circuit lines.

Generic distance protection methods which can be applied to lines connected to IBRs at either or both ends are also recently proposed in the literature. The method proposed in [13] uses a time-domain based approach which requires measurements at high sampling frequency. Retrofitting such solutions into existing installation base is challenging. Furthermore, this method as well as the source independent method proposed in [14] does not consider the mutual coupling effects in double-circuit lines.

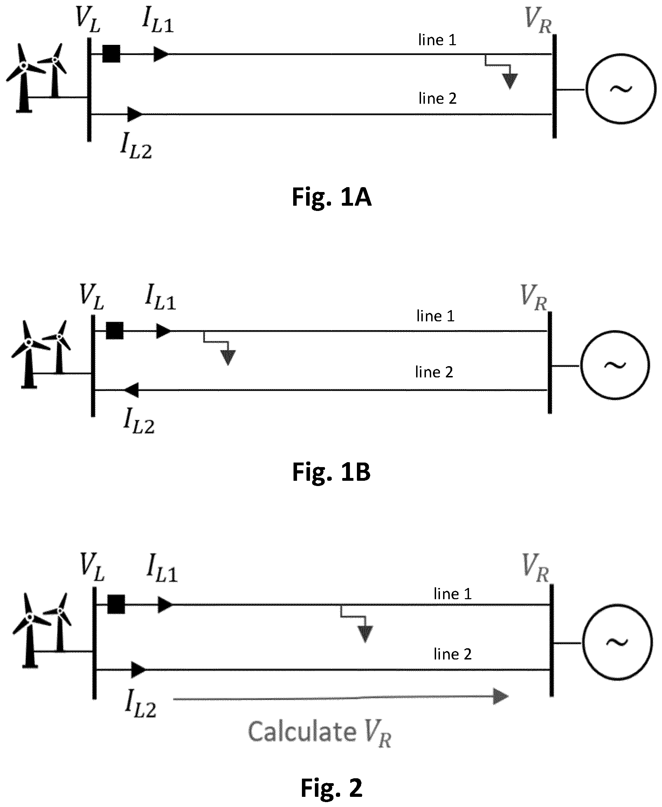

Figs. 1 and 2 show exemplary double-circuit line system configurations and the particular problems associated therewith. The stepped arrows downwards each indicate the location of the fault, $V_x$ and $I_x$ denote voltages and currents, respectively.

Figs. 1 and 2 show a double-circuit line which connects an inverter-based renewable (IBR) to the grid. Fig. 1A and 1B indicate two fault scenarios. For the first fault scenario in Fig. 1A the current on line 2 flows out of the IBR into the fault through the remote end. Thus, the current $IL1$ seen by relay R is purely controlled in nature. In this case the traditional phasor-based distance element [11] will malfunction, whereas distance protection methods proposed for IBR-connected lines in recent literature [9], [10] will work reliably.

Now, consider a second fault scenario as seen in Fig. 1B. The current on line 2 is such that the current from the strong remote grid feeds into the fault through the local end. Thus, the current $IL1$ seen by relay R consists of a significant component from the stronger remote grid. It is not as controlled in nature as in the case of first fault scenario. In this case, the traditional distance element [11] works reliably, whereas new distance protection methods proposed for relays seeing controlled IBR currents will see limitations.

So, for the same system, for different fault scenarios, the performance of traditional and the proposed distance protection methods varies.

Fig. 2 shows a double-circuit line with a generation mix of IBR and a strong synchronous generator-based grid at both ends. In this system, the nature of the current $IL1$ seen by relay R depends on the penetration of the IBR at the local end at the time of fault. This in turn can depend on the time of day, weather, and many other environmental and technical factors. Thus, the current $IL1$ seen by relay R can be controlled or non-controlled in nature. This again creates a scenario, where, depending on various environmental and technical factors, the nature of the relay current varies, and the performance of traditional and proposed distance protection methods [9], [10] varies. It is also to be noted that when both the IBRs in Fig. 2 are feeding into the fault, the recently proposed modified distance protection methods [9], [10] are not reliable. This is because they are based on the assumption that the remote end is connected to traditional generators only and has no penetration of IBR.

It can be concluded from the above that the traditional distance protection method as well as the modified methods proposed in recent literature face limitation when applied to double-circuit lines connected to IBRs of configurations as shown in Figs. 1 and 2.

In addition to this, the modified distance protection methods proposed in recent literature for lines connected to IBRs do not address the issue of mutual coupling in double-circuit lines.

With increased penetration of utility-scale renewable plants at transmission level and majority of EHV lines at transmission levels being double-circuit lines, there is a need for a generic, reliable, local-measurement based line protection method for double-circuit lines connected to IBRs at either or both ends.

Single-ended fault location function also faces challenges when applied to lines connected to IBRs [12].

Hence, there is also a need for a generic, accurate, local-measurement based fault location method for double-circuit lines connected to IBRs at either or both ends.

The present disclosure has been made in view of the above problems.

The invention proposes a generic, single-ended, local measurement-based method for protection and fault location on double-circuit lines connected to IBRs at either or both ends. The method may rely on local voltage measurement and current measurements from both lines as an input (which can be sampled values obtained through process bus at digital substations based on IEC 61850). The method also incorporates the effect of mutual coupling in double-circuit lines. The disclosure also relates to a corresponding device and system.

The disclosure provides a generic, single-ended, local measurement-based method for protection of double-circuit lines connected to IBRs at either or both ends or conventional sources.

Moreover, it can provide secure and dependable protection for 100% of the line, thus eliminating the need for transfer schemes which are popularly utilised in existing distance protection in the field.

The disclosure considers the impact of mutual coupling effects in double-circuit lines which can potentially cause underreach or overreach in existing distance protection methods [11].

The proposed method is very minimally impacted by the magnitude of fault resistance. It provides much better fault resistance coverage when compared to existing and proposed distance protection methods.

It additionally provides accurate fault location, in particular accurate to less than 1% of the total line length.

The invention is specified by the independent claims. Preferred embodiments are defined in the dependent claims. In the following description, although numerous features may be designated as optional, it is nevertheless acknowledged that all features comprised in the independent claims are not to be read as optional.

The present disclosure relates to a method for determining a fault in a double-circuit line comprising a first line and a second line. The method comprises calculating a first angle of a power at a beginning of a monitored line length of the first line, calculating a second angle of a power at an end of the monitored line length of the first line, performing an operation with the first angle and the second angle to calculate a first fault factor, and determining whether the fault is on the first or second line based on a polarity of the first fault factor.

Various embodiments may preferably implement the following features.

Preferably, the operation is a multiplication, a division, a logical operation or performed using a truth table.

Preferably, the fault is determined to be on the first line in case the first fault factor is of a first polarity, and the fault is determined to be on the second line in case the sign of the first fault factor is of a second polarity.

Preferably, the polarity comprises a sign of the first fault factor.

Preferably, the fault is determined to be on the first line in case the sign of the first fault factor is negative, and the fault is determined to be on the second line in case the sign of the first fault factor is positive.

Preferably, the method further comprises acquiring local voltage and current measurements of the first and second line, wherein the calculation of the first angle and the second angle are performed using the local voltage and current measurements of the first and second line.

Preferably, the method further comprises calculating a fault angle over the complete monitored line length of the line having the fault, wherein the location of the fault is determined based on a zero crossing of the fault angle.

Preferably, the method further comprises acquiring local voltage and current measurements of the first and second line, calculating a first bus voltage at the end of the monitored line length of the first line based on the local voltage and current measurements of the first line, calculating a second bus voltage at an end of a monitored line length of the second line based on the local voltage and current measurements of the second line and determining whether the fault is inside or outside of the monitored line length based on the first and second bus voltage.

Preferably, the fault is determined to be outside of the monitored line length in case a difference between a norm of the first bus voltage and a norm of the second bus voltage is equal or less than a predetermined threshold and the fault is determined to be inside of the monitored line length in case a difference between a norm of the first bus voltage and a norm of the second bus voltage is higher than the predetermined threshold.

Preferably, the monitored line length of the first line and the second line are equal.

Preferably, the method further comprises calculating a third angle of a power at a beginning of a monitored line length of the second line, calculating a fourth angle of a power at an end of the monitored line length of the second line, multiplying the third angle and the fourth angle to calculate a second fault factor, and determining whether the fault is on the first or second line based on the sign of the second fault factor.

Preferably, the fault is determined to be on the second line in case the second fault factor is negative and the fault is determined to be on the first line in case the second fault factor is positive.

Preferably, the method further comprises acquiring local voltage and current measurements of the first and second line, wherein the calculation of the third angle and the fourth angle are performed using the local voltage and current measurements of the first and second line.

Preferably, the power is calculated as a sum of a positive sequence power, a negative sequence power and a zero sequence power of the first and/or the second line.

The disclosure further relates to a device for determining a fault in a double circuit line comprising a first line and a second line, wherein the device is connected to the first line and the second line and comprises a processor configured to calculate a first angle of a power at a beginning of a monitored line length of the first line, calculate a second angle of a power at an end of the monitored line length of the first line, performing an operation with the first angle and the second angle to calculate a first fault factor, and determine whether the fault is on the first or second line based on the first fault factor.

Various embodiments may preferably implement the following features.

Preferably, the operation is multiplication, a division, a logical operation or performed using a truth table.

Preferably, the processor is configured to determine the fault to be on the first line in case the first fault factor is of a first polarity, and to determine the fault to be on the second line in case the sign of the first fault factor is of a second polarity.

Preferably, the polarity comprises a sign of the first fault factor.

Preferably, the processor is configured to determine the fault to be on the first line in case the sign of the first fault factor is negative, and to determine the fault to be on the second line in case the sign of the first fault factor is positive.

Preferably, the processor is further configured to acquire local voltage and current measurements of the first and second line, and to perform the calculation of the first angle and the second angle using the local voltage and current measurements of the first and second line.

Preferably, the processor is configured to calculate a fault angle over the complete monitored line length of the line having the fault, and to determine the location of the fault based on a zero crossing of the fault angle.

Preferably, the processor is configured to acquire local voltage and current measurements of the first and second line, calculate a first bus voltage at the end of the monitored line length of the first line based on the local voltage and current measurements of the first line, calculate a second bus voltage at an end of a monitored line length of the second line based on the local voltage and current measurements of the second line and determine whether the fault is inside or outside of the monitored line length based on the first and second bus voltage.

Preferably, the processor is configured to determine the fault to be outside of the monitored line length in case a difference between a norm of the first bus voltage and a norm of the second bus voltage is equal or less than a predetermined threshold and to determine the fault to be inside of the monitored line length in case a difference between a norm of the first bus voltage and a norm of the second bus voltage is higher than the predetermined threshold.

Preferably, the monitored line length of the first line and the second line are equal.

Preferably, the processor is configured to calculate a third angle of a power at a beginning of a monitored line length of the second line, calculate a fourth angle of a power at an end of the monitored line length of the second line, multiply the third angle and the fourth angle to calculate a second fault factor, and determine whether the fault is on the first or second line based on the sign of the second fault factor.

Preferably, the processor is configured to determine the fault to be on the second line in case the second fault factor is negative and to determine the fault to be on the first line in case the second fault factor is positive.

Preferably, the processor is configured to acquire local voltage and current measurements of the first and second line, and to perform the calculation of the third angle and the fourth angle using the local voltage and current measurements of the first and second line.

Preferably, the processor is configured to calculate the power as a sum of a positive sequence power, a negative sequence power and a zero sequence power of the first and/or the second line.

The disclosure also relates to a system for determining a fault in a double circuit line comprising a first line and a second line and the device as described above.

Other aspects, features, and advantages will be apparent from the summary above, as well as from the description that follows, including the figures and the claims.

Figs. 1 and 2 show exemplary double-circuit line system configurations.

Fig. 3 shows a flow chart of a high-level design of an embodiment of the present disclosure.

Fig. 4 shows a double circuit transmission line test system according to an embodiment of the present disclosure.

Figs. 5A and 5B are plots of an angle of the total fault path power over the line length according to an embodiment of the present disclosure.

Fig. 6 is a positive sequence equivalent network after a fault according to an embodiment of the present disclosure.

Fig. 7 is a zero sequence equivalent network after a fault according to an embodiment of the present disclosure.

Fig. 8 is a plot of an angle of the total fault path power over the line length according to an embodiment of the present disclosure.

Fig. 9 is a flowchart of a method according to an embodiment of the present disclosure.

Fig. 10 is a flowchart of a method according to an embodiment of the present disclosure.

Fig. 11 shows a configuration according to an embodiment of the present disclosure.

In the following, the terms "first/second line", "L1/L2" and "line 1/line 2" denote the same and may be used interchangeably. Moreover, a voltage is denoted by the symbol *"V"* while a current is denoted by the symbol "1".

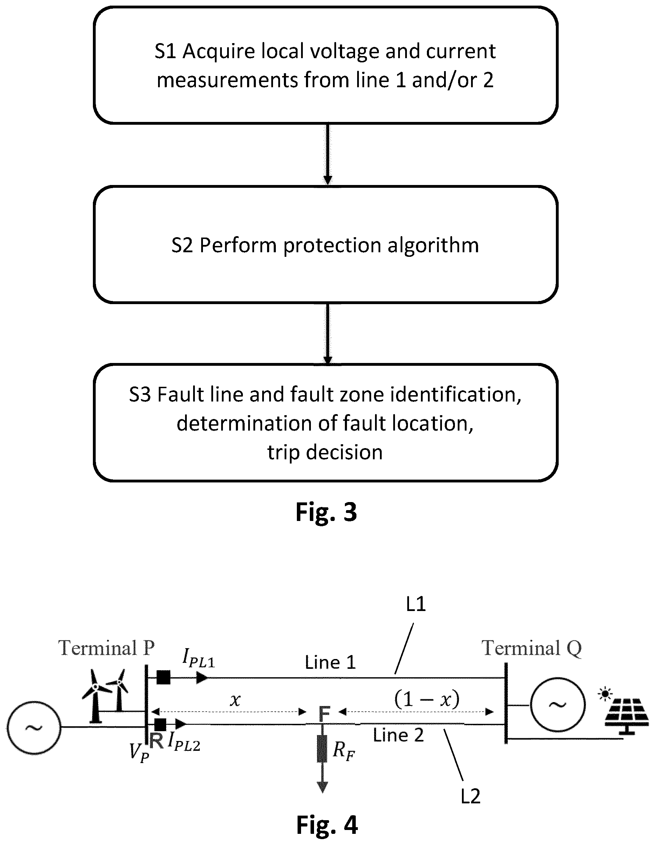

Fig. 3 shows a flow chart of a high-level design of an embodiment of the present disclosure. In this embodiment, the proposed method identifies whether a fault is in the pre-determined zone of protection of the line being protected in a double-circuit line 2 using local voltage and current measurements from both the lines. In particular, the method includes acquiring S1 local voltage and current measurements from line 1 and/or 2, performing S2 a protection algorithm and identifying S3 a fault line and fault zone, determining a fault location, and acquiring a trip decision.

Fig. 4 shows a double circuit transmission line test system to further describe the principle of the present disclosure. The following refers to an embodiment of the present disclosure.

In the example of Fig. 4, the fault is on line 2 at F at a distance x from terminal P (*x* is expressed as a fraction of the total line length).

The total power across the fault path (F to ground through *RF*) for a fault on a transmission line can be calculated as follows.

$$S_F = V_F I_F^* \tag{1}$$

Where, $V_F$ is the fault point voltage at F and $I_F$ is the fault path current flowing through the fault resistance $R_F$.

This can be written as a sum of the individual positive, negative and zero sequence components:

$$S_F = V_F^1 I_F^{1^*} + V_F^2 I_F^{2^*} + V_F^0 I_F^{0^*} \tag{2}$$

The superscripts 1, 2 and 0 denote positive, negative and zero sequences. Since the fault path resistance $R_F$ for a fault on a transmission line is majorly resistive in nature, the angle of the total power $S_F$ will be very close to zero. This property can be used to identify if there is a fault in a protected zone of a transmission line. The basic steps according to an embodiment are listed below.

Step 1: Firstly, after fault event detection, it is classified if the fault is within the terminals P and Q in Fig. 4 or external to it (i.e., bus faults and faults behind P or beyond Q). This is done by calculating the voltage at remote Bus Q from local Bus P, through line 1 and line 2 and comparing them.

In particular, a positive Bus Q voltage from Bus P through line 1, $V_{QcL1}^1$, is calculated:

$$V_{QcL1}^1 = A_{L1}^1 V_P^1 + B_{L1}^1 I_{PL1}^1 \tag{3}$$

Moreover, the positive Bus Q voltage from Bus P through line 2, $V_{QcL2}^1$, is calculated:

$$V_{QcL2}^1 = A_{L2}^1 V_P^1 + B_{L2}^1 I_{PL2}^1 \tag{4}$$

where

$$A_{L1}^1 = -D_{L1}^1 = \cosh(\gamma^1 L), \quad B_{L1}^1 = -Z_c^1 \sinh(\gamma^1 L), \quad D_{L1}^1 = \frac{1}{z_c^1}\sinh(\gamma^1 L)$$

$$Z_c^1 = \sqrt{(r^1 + j\omega l^1)\Big/(j\omega c^1)}, \quad \gamma^1 = \sqrt{(r^1 + j\omega l^1)(j\omega c^1)}$$

and $r^1$, $l^1$ and $c^1$ are positive sequence resistance, inductance and capacitance per unit length of the line.

Subscripts L1 and L2 denote line 1 and line 2, respectively. Superscript 1 denotes a positive sequence component.

If the fault is behind Bus P or beyond Bus Q, both these calculated voltages will be almost equal and in particular, a difference will be less than a pre-set threshold, i.e., $\left| \left| V_{QcL1}^1 \right| - \left| V_{QcL2}^1 \right| \right| < \epsilon$ .

If $\left| \left| V_{QcL1}^1 \right| - \left| V_{QcL2}^1 \right| \right| > \epsilon$ , the faulty line, the zone and the location of the fault are identified.

Otherwise, the fault is identified to be an external fault.

Step 2: If the fault is determined to be between Bus P and Q, assuming that the fault is on line 2, the sequence components of fault point voltage $(V_F)$ and current $(I_F)$ are expressed as a function of the unknown fault location $x$ on the line: $V_F^1(x), V_F^2(x), V_F^0(x), I_F^1(x), I_F^2(x), I_F^0(x)$ .

The superscripts 1, 2 and 0 denote positive, negative and zero sequences, respectively.

Step 3: The total power $S_F(x)$ in the fault path is expressed as function of the unknown fault location x on the line.

$$S_F(x) = S_F^1(x) + S_F^2(x) + S_F^0(x) = V_F^1(x)I_F^1(x)^* + V_F^2(x)I_F^2(x)^* + V_F^0(x)I_F^0(x)^* \tag{5}$$

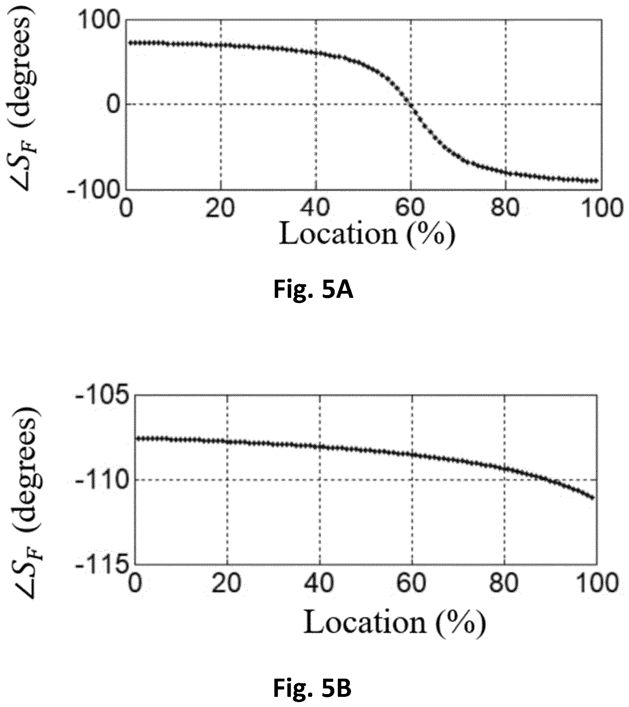

Step 4: If the angle of $S_F(x)$ is plotted for various locations on the line being protected, it will produce a plot similar to the one in Fig. 5A, when there is actually a fault on the line. The angle will cross zero at the actual fault location. For locations on the line before the fault point the angle will have a positive value and for locations on the line after the fault point the angle will have a negative value. If the fault is on line 1, the plot of the angle will not have a zero crossing as exemplarily shown in Fig. 5B.

To identify if the fault is on line 2 (since in this example, derivations are made on the assumption that the fault is on line 2) a factor $\Psi_{\angle SF}^{L2}$ is calculated as below:

$$\psi_{\angle SF}^{L2} = \angle S_F(0)\, \angle S_F(z_b)$$

Where, $\angle S_F(0)$ is the angle of the total fault path power calculated assuming that the fault is the local terminal (i.e., substituting $x = 0$ in equation 5) and $\angle S_F(z_b)$ is the angle of the total fault path power calculated assuming that the fault is the boundary of the zone of protection (i.e., substituting $x = z_b$ in equation 5). The zone of boundary can be set to cover the full line length ($z_b=1$) or a particular percentage of the line, e.g., 80% ($z_b=0.8$).

As can be seen from Fig. 5, if the fault is on the protected zone of the line 2, $\Psi_{\angle SF}^{L2}$ will be negative. If the fault is on the other line, i.e., line 1, $\Psi_{\angle SF}^{L2}$ will be positive. Thus, if $\Psi_{\angle SF}^{L2}$ is negative, the fault is determined to be on line 2, and $\Psi_{\angle SF}^{L2}$ is positive, the fault is determined to be on line 1.

The factor $\Psi_{\angle SF}^{L2}$ may also be calculated by a division, a logical operation or using a truth table.

Fig. 5A shows a diagram of the total fault path power angle $\angle S_F$ over the location on the line in percentage of the total line length assuming that the fault is on line 2. As can be seen by the zero crossing, the fault can be determined to be at 60% of the total protected line length of line 2.

Fig. 5B shows a diagram of the total fault path power angle $\angle S_F$ over the location on the line in percentage of the total line length assuming that the fault is on line 1. No zero crossing can be observed.

In an embodiment, if faults on line 1 and 2 are assumed, two factors $\Psi^{L1}_{\angle SF}$ and $\Psi^{L2}_{\angle SF}$ for lines 1 and 2, respectively, may be obtained. A decision may be made as below.

| $\Psi^{L1}_{\angle SF}$ | $\Psi^{L2}_{\angle SF}$ | Decision |
|---|---|---|
| negative | positive | Fault on line 1 |
| positive | negative | Fault on line 2 |

A more detailed derivation of $\angle S_F(x)$ to calculate $\Psi^{L2}_{\angle SF}$ assuming a fault on line 2 is described below.

A similar derivation can be carried out assuming the fault is on line 1 to calculate $\Psi^{L1}_{\angle SF}$.

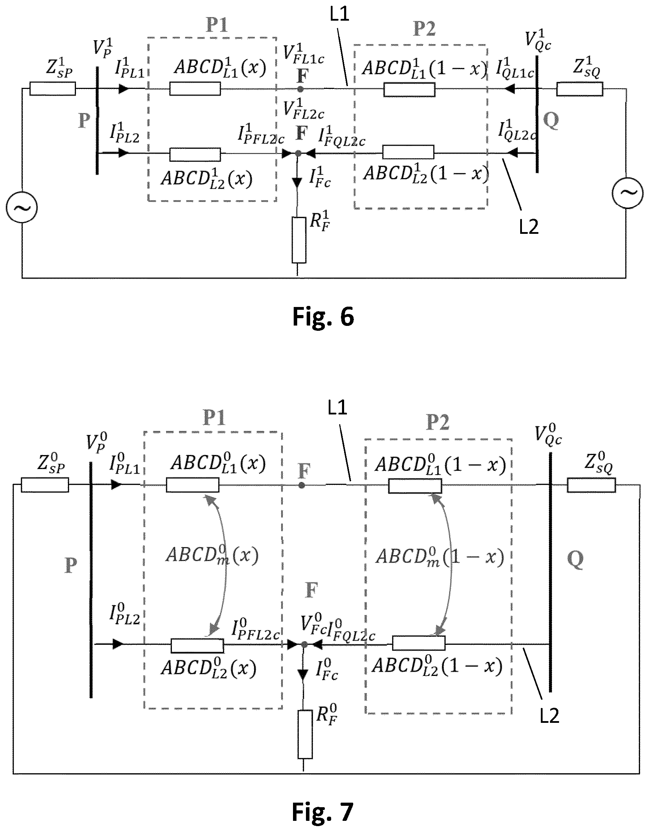

The positive sequence network derivations will be described referring to Fig. 6.

First, a positive sequence fault point voltage $V^1_{FL2c}$ on the faulty line 2 is calculated.

For the positive sequence network P1 between terminal P and fault bus F (see Fig.6), the following relations can be formed:

$$\begin{bmatrix} V^1_{FL1c}(x) \\ I^1_{PFL1c}(x) \\ V^1_{FL2c}(x) \\ I^1_{PFL2c}(x) \end{bmatrix} = \begin{bmatrix} A^1_{L1}(x) & B^1_{L1}(x) & 0 & 0 \\ C^1_{L1}(x) & D^1_{L1}(x) & 0 & 0 \\ 0 & 0 & A^1_{L2}(x) & B^1_{L2}(x) \\ 0 & 0 & C^1_{L2}(x) & D^1_{L2}(x) \end{bmatrix} \begin{bmatrix} V^1_P \\ I^1_{PL1} \\ V^1_P \\ I^1_{PL2} \end{bmatrix} \tag{1}$$

where

$$A^1_{L1}(x) = -D^1_{L1}(x) = \cosh(\gamma^1 xL), \quad B^1_{L1}(x) = -Z^1_c \sinh(\gamma^1 xL), \quad C^1_{L1}(x) = \frac{1}{Z^1_c}\sinh(\gamma^1 xL)$$

$$Z^1_c = \sqrt{(r^1 + j\omega l^1)\big/(j\omega c^1)}, \quad \gamma^1 = \sqrt{(r^1 + j\omega l^1)(j\omega c^1)}$$

and $r^1$, $l^1$ and $c^1$ are positive sequence resistance, inductance, and capacitance, respectively, per unit length of the line.

Solving equation (1) above results in the positive-sequence fault point voltage $V^1_{FL2c}$ on the faulty line 2 in terms of the fault location $x$ using only the local measurements.

$$V^1_{FL2c}(x) = A^1_{L2}(x)V^1_P + B^1_{L2}(x)I^1_{PL2} \tag{2}$$

Next, the positive sequence fault path current $I^1_{Fc}$ on the faulty line is calculated.

The fault current fed from the local terminal P, $I^1_{PFL2c}$, can be obtained from the second row of equation (1) above.

$$I^1_{PFL2c}(x) = C^1_{L2}(x)V^1_P + D^1_{L2}(x)I^1_{PL2} \tag{3}$$

Now, to obtain a positive-sequence component of the fault current fed from the remote terminal Q, $I^1_{FQL2c}$, the port equations for port P2 in a positive-sequence equivalent network in Fig. 6 can be written as follows.

$$\begin{bmatrix} V^1_{Qc}(x) \\ I^1_{QL1c}(x) \\ V^1_{Qc}(x) \\ I^1_{QL2c}(x) \end{bmatrix} = \begin{bmatrix} A^1_{L1}(1-x) & B^1_{L1}(1-x) & 0 & 0 \\ C^1_{L1}(1-x) & D^1_{L1}(1-x) & 0 & 0 \\ 0 & 0 & A^1_{L2}(1-x) & B^1_{L2}(1-x) \\ 0 & 0 & C^1_{L2}(1-x) & D^1_{L2}(1-x) \end{bmatrix} \begin{bmatrix} V^1_{FL1c}(x) \\ I^1_{FQL1c}(x) \\ V^1_{FL2c}(x) \\ I^1_{FQL2c}(x) \end{bmatrix} \tag{4}$$

After equating $V^1_{Qc}(x)$ calculated from the first and third rows in equation (4), the following expression for $I^1_{FQL2c}$ can be derived.

$$I^1_{FQL2c}(x) = \frac{\left(A^0_{L1}(1-x)\right)V^1_{FL1c}(x) + \left(B^1_{L1}(1-x)\right)I^1_{FQL1c}(x) - \left(A^1_{L2}(1-x)\right)V^1_{FL2c}(x)}{\left(B^1_{L2}(1-x)\right)} \tag{5}$$

where $V^1_{FL1c}(x) = A^1_{L1}(x)V^1_P + B^1_{L1}(x)I^1_{PL1}$ from equation (1), $I^1_{FQL1c}(x) = I^1_{PFL1c}(x)$ since there is no fault assumed in line 1 and $V^1_{FL2c}(x)$ is calculated in equation (2).

The total positive sequence fault path current on the faulty line 2, $I^1_{Fc}(x)$, can be written as a function of x as below.

$$I^1_{Fc}(x) = I^1_{PFL2c}(x) + I^1_{FQL2c}(x) \tag{6}$$

Next, the positive sequence fault path power $S^1_F(x)$ is calculated.

Using the calculated positive sequence fault point voltage $V^1_{FL2c}$ and the fault path current $I^1_{Fc}$, the total positive sequence fault path power can be calculated as

$$S^1_F(x) = V^1_{FL2c}(x)I^1_{Fc}(x)^* \tag{7}$$

Next, the negative sequence network derivations will be described.

The negative sequence fault point voltage $V^2_{FL2c}$ and the negative sequence fault path current $I^2_{Fc}$ can be calculated similar to the positive sequence derivations, by replacing all positive sequence quantities with negative sequence quantities. The negative sequence networks for both the lines are also decoupled.

Using the calculated negative sequence fault point voltage $V^2_{FL2c}$ and the fault path current $I^2_{Fc}$, the total negative sequence fault path power can be calculated as

$$S^2_F(x) = V^2_{FL2c}(x)I^2_{Fc}(x)^* \tag{8}$$

Next, the zero sequence network derivations will be described with reference to Fig. 7.

The zero sequence fault point voltage on the faulty line (here, line 2), $V^0_{FL2c}$, can be calculated as follows.
Zero sequence networks of both the lines are not decoupled since the sum of zero-sequence currents flowing through a circuit is non-zero. Hence, the equations for P1 for the zero-sequence network shown in Fig. 7 can be written as below.

$$
\begin{bmatrix} V^0_{FL1c}(x) \\ I^0_{PFL1c}(x) \\ V^0_{FL2c}(x) \\ I^0_{PFL2c}(x) \end{bmatrix} = \begin{bmatrix} A^0_{L1}(x) & B^0_{L1}(x) & A^0_m(x) & B^0_m(x) \\ C^0_{L1}(x) & D^1_{L1}(x) & C^0_m(x) & D^0_m(x) \\ A^0_m(x) & B^0_m(x) & A^0_{L2}(x) & B^0_{L2}(x) \\ C^0_m(x) & D^0_m(x) & C^0_{L2}(x) & D^0_{L2}(x) \end{bmatrix} \begin{bmatrix} V^0_P \\ I^0_{PL1} \\ V^0_P \\ I^0_{PL2} \end{bmatrix} \tag{9}
$$

Equation (9) is solved to obtain the zero-sequence fault point voltage on the faulty line 2, $V^0_{FL2c}$, in terms of the fault location $x$ using only the local measurements.

$$
V^0_{FL2c}(x) = A^0_m(x)V^0_P + B^0_m(x)I^0_{PL1} + A^0_{L2}(x)V^0_P + B^0_{L2}(x)I^0_{PL2} \tag{10}
$$

Next, the zero sequence fault path current $I^0_{Fc}$ on the faulty line is calculated.

The zero-sequence component of the fault current fed from the local terminal P, $I^0_{PFL2c}$ can be obtained from the last row of equation (9).

$$
I^0_{PFL2c}(x) = C^0_m(x)V^0_P + D^0_m(x)I^0_{PL1} + C^0_{L2}(x)V^0_P + D^0_{L2}(x)I^0_{PL2} \tag{11}
$$

Now, to obtain the zero-sequence component of the fault current fed from the remote terminal Q, $I^0_{FQL2c}$ the port equations for port P2 in the zero-sequence equivalent network in Fig. 7 can be written as follows.

$$
\begin{bmatrix} V^0_{Qc}(x) \\ I^0_{QL1c}(x) \\ V^0_{Qc}(x) \\ I^0_{QL2c}(x) \end{bmatrix} = \begin{bmatrix} A^0_{L1}(1-x) & B^0_{L1}(1-x) & A^0_m(1-x) & B^0_m(1-x) \\ C^0_{L1}(1-x) & D^0_{L1}(1-x) & C^0_m(1-x) & D^0_m(1-x) \\ A^0_m(1-x) & B^0_m(1-x) & A^0_{L2}(1-x) & B^0_{L2}(1-x) \\ C^0_m(1-x) & D^0_m(1-x) & C^0_{L2}(1-x) & D^0_{L2}(1-x) \end{bmatrix} \begin{bmatrix} V^0_{FL1c}(x) \\ I^0_{FQL1c}(x) \\ V^0_{FL2c}(x) \\ I^0_{FQL2c}(x) \end{bmatrix} \tag{12}
$$

After equating $V^0_{Qc}(x)$ calculated from the first and third rows in equation (12), the following expression shown below can be derived for $I^0_{FQL2c}$.

$$
\begin{aligned}
&I^0_{FQL2c}(x) \\
&= \frac{(A^0_{L1}(1-x) - A^0_m(1-x))V^0_{FL1c}(x) + (B^0_{L1}(1-x) - B^0_m(1-x))I^0_{FQL1c}(x) + (A^0_m(1-x) - A^0_{L2}(1-x))V^0_{FL2c}(x)}{(B^0_{L2}(1-x) - B^0_m(1-x))}
\end{aligned} \tag{13}
$$

The total zero sequence fault path current $I^0_{Fc}(x)$ on the faulty line 2 can be written as a function of $x$.

$$
I^0_{Fc}(x) = I^0_{PFL2c}(x) + I^0_{FQL2c}(x) \tag{14}
$$

Next, the zero sequence fault path power $S^0_F(x)$ is calculated.

Using the calculated zero sequence fault point voltage $V^0_{FL2c}$ and fault path current $I^0_{Fc}$, the total zero sequence fault path power can be calculated as:

$$S_F^0(x) = V_{FL2c}^0(x)I_{Fc}^0(x)^* \qquad\qquad (15)$$

Now, the logic for the trip decision, i.e., whether to operate a circuit breaker or similar grid element, will be described.

In order to identify whether the fault is on line 2, a factor $\Psi_{\angle SF}^{L2}$ is calculated as shown below,

$$\psi_{\angle SF}^{L2} = \angle S_F(0) \angle S_F(z_b)$$

where $\angle S_F(0)$ is the angle of the total fault path power calculated assuming that the fault is at the local terminal (i.e., $x = 0$) and $\angle S_F(z_b)$ is the angle of total fault path power calculated assuming that the fault is the boundary of the zone of protection ($x = z_b$). As described above, zone of protection can be sent to cover the full line length ($z_b=1$) or a particular percentage of the line, e.g., 80% ($z_b=0.8$). $\Psi_{\angle SF}^{L2}$ is negative, the fault is determined to be on line 2. $\Psi_{\angle SF}^{L2}$ is positive, the fault is determined to be on line 1.

Next, the identification of the fault location will be described.

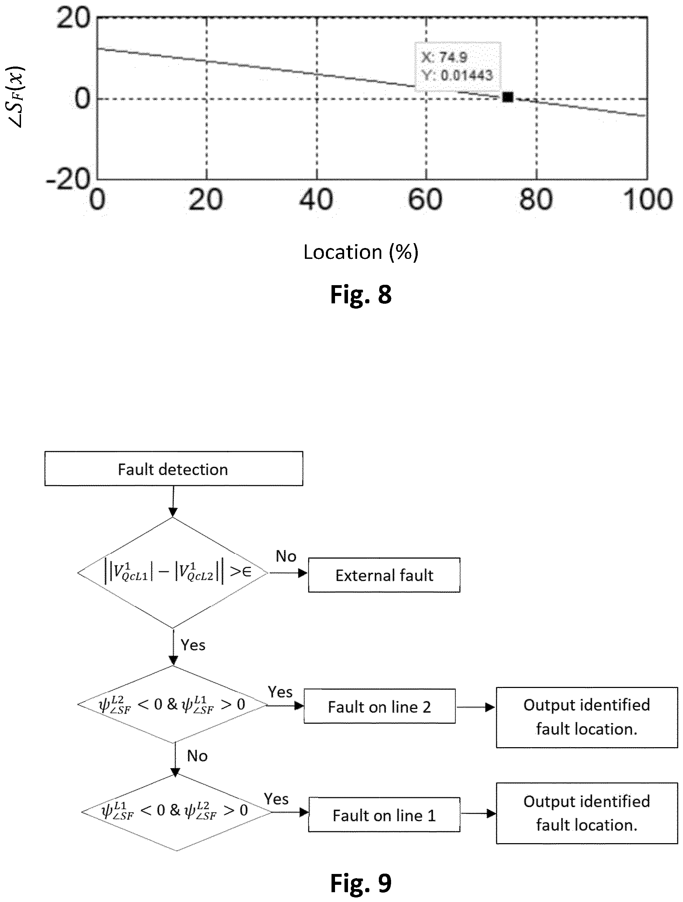

In addition to protection, the method as disclosed herein also provides the fault location as an output. Fig. 8 shows a plot of $\angle S_F(x)$ assuming a fault on line 2 for an Ag fault at 75% of the line length from Bus P, with a high Rf 50Ω. It can be seen that the plot passes through zero at the accurate fault location with minimal deviation. Thus, the fault location can be identified through any numerical method, e.g., a bisection method. In this case, the fault location is identified to be at 74.9% of the line length which means that the error is only 0.1%.

The above calculations have mainly been described with reference to line 2. However, the calculations are equally applicable to line 1.

Fig. 9 is a further flow chart of an embodiment according to the present disclosure. For detailed explanations and calculations, reference is made to the above.

In a first step of the fault detection, it is determined whether an external fault is existent by calculating whether the difference between the positive bus voltages $\left|\left|V_{QcL1}^1\right| - \left|V_{QcL2}^1\right|\right|$ is higher or lower than a predetermined threshold C. In case the difference is smaller than the threshold 6, the fault is determined to be an external fault ("no"). In case the difference is higher than the threshold 6, it is proceeded with determining the faulty line.

In particular, $\Psi_{\angle SF}^{L2} < 0$ and $\Psi_{\angle SF}^{L1} > 0$, the fault is determined to be on line 2. The fault location can be determined using the zero crossing as described above.

If $\Psi_{\angle SF}^{L1} < 0$ and $\Psi_{\angle SF}^{L2} > 0$, the fault is determined to be on line 1. The fault location can be determined using the zero crossing as described above.

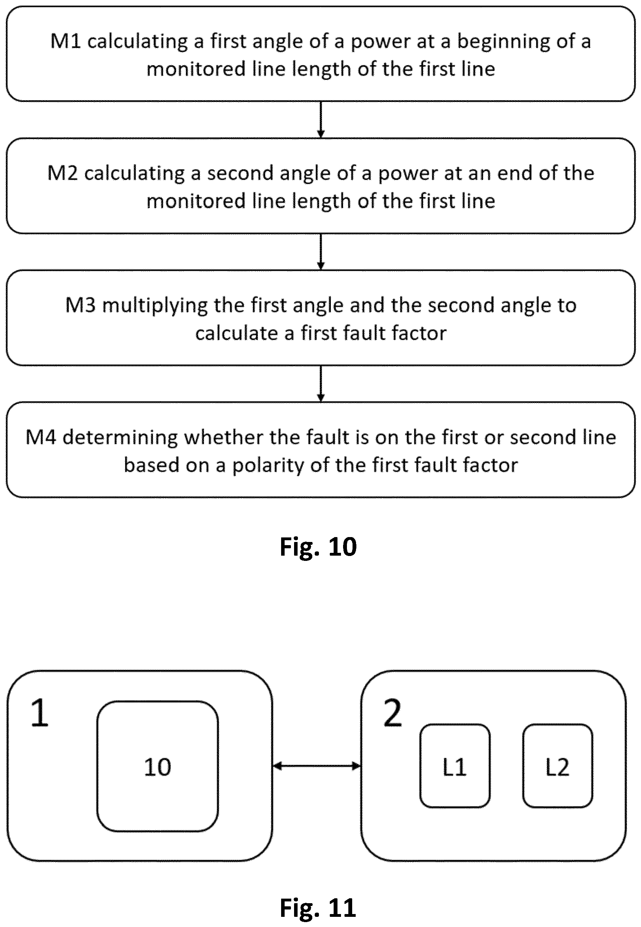

An embodiment of the present disclosure as shown in the flowchart of Fig. 10 relates to a method for determining a fault in a double-circuit line 2 comprising a first line L1 and a second line L2. The method comprises calculating M1 a first angle of a power at a beginning of a monitored line length of the first line L1, calculating M2 a second angle of a power at an end of the monitored line length of the first line L1, multiplying M3 the first angle and the second angle to calculate a first fault factor, and determining M4 whether the fault is on the first or second line L2 based on a polarity of the first fault factor.

The multiplication step M3 may also be another mathematical operation such as a division, any other logical operation or may be performed using a truth table

The line numbering line 1 and line 2 is not to be seen as restricting and can be inverted as necessary.

For this embodiment, the first angle of a power at a beginning of a monitored line length ($x = 0$) may be $\angle S_F(0)$, and the second angle of a power at an end of the monitored line length may be $\angle S_F(z_b)$, wherein $z_b$ is the location on the monitored line length as described above with $0 < z_b \leq 1$.

The first fault factor of the first line L1 may thus be $\Psi_{\angle SF}^{L1} = \angle S_F(0) \angle S_F(z_b)$.

The beginning of the line length may be a bus connecting the energy source (e.g., IBR) or another element to the line. Similarly, the end of the line length may be a bus connecting the line to a grid, an energy source or another element. The monitored line length may be 100% of the line length (i.e., the actual line length from bus to bus) or a part thereof. For example, the beginning of the monitored line length may be at 20% of the (actual) line length, preferably at 10% and more preferably at 0%, and the end of the monitored line length may be at 80% of the (actual) line length, preferably at 90%, more preferably at 95% and more preferably at 100%. Combinations thereof may also be possible. A preferred monitored line length may be 0-80% of the actual line length. It is thus understood that the term "beginning/end of the line length" as used herein may also refer to "beginning/end of the monitored line length" which may not necessarily coincide as outlined above.

In an embodiment, the fault is determined to be on the first line L1 in case the first fault factor is of a first polarity, and the fault is determined to be on the second line L2 in case the sign of the first fault factor is of a second polarity.

In an embodiment, the polarity comprises a sign of the first fault factor.

In an embodiment, the fault is determined to be on the first line L1 in case the sign of the first fault factor is negative, and the fault is determined to be on the second line L2 in case the sign of the first fault factor is positive.

In an embodiment, the method further comprises acquiring local voltage and current measurements of the first and second line L2, wherein the calculation of the first angle and the second angle are performed using the local voltage and current measurements of the first and second line L2.

In an embodiment, the method further comprises calculating a fault angle over the complete monitored line length of the line having the fault, wherein the location of the fault is determined based on a zero crossing of the fault angle.

Therein, the fault angle is $\angle S_F(x)$, wherein $0 \leq x \leq z_b$.

In an embodiment, the method further comprises acquiring local voltage and current measurements of the first and second line L2, calculating a first bus voltage at the end of the monitored line length of the first line L1 based on the local voltage and current measurements of the first line L1, calculating a second bus voltage at an end of a monitored line length of the second line L2 based on the local voltage and current measurements of the second line L2 and determining whether the fault is inside or outside of the monitored line length based on the first and second bus voltage.

The buses may be P and/or Q. The first bus voltage may be $V_{QcL1}^1$, and the second bus voltage may be $V_{QcL2}^1$.

In an embodiment, the fault is determined to be outside of the monitored line length in case a difference between a norm of the first bus voltage and a norm of the second bus voltage is equal or less than a predetermined threshold and the fault is determined to be inside of the monitored line length in case a difference between a norm of the first bus voltage and a norm of the second bus voltage is higher than the predetermined threshold.

The norm may be $\left| \left| V_{QcL1}^1 \right| - \left| V_{QcL2}^1 \right| \right|$ and the threshold may be C.

In an embodiment, the monitored line length of the first line L1 and the second line L2 are equal.

In an embodiment, the method further comprises calculating a third angle of a power at a beginning of a monitored line length of the second line L2, calculating a fourth angle of a power at an end of the monitored line length of the second line L2, multiplying the third angle and the fourth angle to calculate a second fault factor, and determining whether the fault is on the first or second line L2 based on the sign of the second fault factor.

For this embodiment, the third angle of a power at a beginning of a monitored line length of the second line L2 ($x = 0$) may be $\angle S_F(0)$, and the second angle of a power at an end of the monitored line length of the second line L2 may be $\angle S_F(z_b)$, wherein $z_b$ is the location on the monitored line length as described above with $0 < z_b \leq 1$.

The first fault factor of the second line L2 may thus be $\Psi_{\angle SF}^{L2} = \angle S_F(0) \, \angle S_F(z_b)$.

In an embodiment, the fault is determined to be on the second line L2 in case the second fault factor is negative and the fault is determined to be on the first line L1 in case the second fault factor is positive.

In an embodiment, the method further comprises acquiring local voltage and current measurements of the first and second line L2, wherein the calculation of the third angle and the fourth angle are performed using the local voltage and current measurements of the first and second line L2.

In an embodiment, the power is calculated as a sum of a positive sequence power, a negative sequence power and a zero sequence power of the first and/or the second line L2.

An embodiment of the present disclosure further relates to a device 1 for determining a fault in a double circuit line 2 comprising a first line L1 and a second line L2, wherein the device 1 is connected to the first line L1 and the second line L2. The device 1 is configured to perform the method as described herein. A configuration of the device is shown in Fig. 11.

The device 1 comprises a processor 10 configured to calculate a first angle of a power at a beginning of a monitored line length of the first line L1, calculate a second angle of a power at an end of the monitored line length of the first line L1, multiply the first angle and the second angle to calculate a first fault factor, and determine whether the fault is on the first or second line L2 based on the first fault factor.

In an embodiment, the processor 10 is configured to determine the fault to be on the first line L1 in case the first fault factor is of a first polarity, and to determine the fault to be on the second line L2 in case the sign of the first fault factor is of a second polarity.

In an embodiment, the polarity comprises a sign of the first fault factor.

In an embodiment, the processor 10 is configured to determine the fault to be on the first line L1 in case the sign of the first fault factor is negative, and to determine the fault to be on the second line L2 in case the sign of the first fault factor is positive.

In an embodiment, the processor 10 is further configured to acquire local voltage and current measurements of the first and second line L2, and to perform the calculation of the first angle and the second angle using the local voltage and current measurements of the first and second line L2.

In an embodiment, the processor 10 is configured to calculate a fault angle over the complete monitored line length of the line having the fault, and to determine the location of the fault based on a zero crossing of the fault angle.

In an embodiment, the processor 10 is configured to acquire local voltage and current measurements of the first and second line L2, calculate a first bus voltage at the end of the monitored line length of the first line L1 based on the local voltage and current measurements of the first line L1, calculate a second bus voltage at an end of a monitored line length of the second line L2 based on the local voltage and current measurements of the second line L2 and determine whether the fault is inside or outside of the monitored line length based on the first and second bus voltage.

In an embodiment, the processor 10 is configured to determine the fault to be outside of the monitored line length in case a difference between a norm of the first bus voltage and a norm of the second bus voltage is equal or less than a predetermined threshold and to determine the fault to be inside of the monitored line length in case a difference between a norm of the first bus voltage and a norm of the second bus voltage is higher than the predetermined threshold.

In an embodiment, the monitored line length of the first line L1 and the second line L2 are equal.

In an embodiment, the processor 10 is configured to calculate a third angle of a power at a beginning of a monitored line length of the second line L2, calculate a fourth angle of a power at an end of the monitored line length of the second line L2, multiply the third angle and the fourth angle to calculate a second fault factor, and determine whether the fault is on the first or second line L2 based on the sign of the second fault factor.

In an embodiment, the processor 10 is configured to determine the fault to be on the second line L2 in case the second fault factor is negative and to determine the fault to be on the first line L1 in case the second fault factor is positive.

In an embodiment, the processor 10 is configured to acquire local voltage and current measurements of the first and second line L2, and to perform the calculation of the third angle and the fourth angle using the local voltage and current measurements of the first and second line L2.

In an embodiment, the processor 10 is configured to calculate the power as a sum of a positive sequence power, a negative sequence power and a zero sequence power of the first and/or the second line L2.

The disclosure also relates to a system for determining a fault in a double circuit line 2 comprising a first line L1 and a second line L2 and the device 1 as described above.

According to the present disclosure, a generic, single-ended, local measurement-based method for protection of double-circuit lines connected to IBRs at either or both ends or conventional sources is presented.

It can provide secure and dependable protection for 100% of the line, thus eliminating the need for transfer schemes which are popularly utilised in existing distance protection in the field.

It also takes care of the impact of mutual coupling effect in double-circuit lines which can potentially cause underreach or overreach in existing distance protection methods [11].

The proposed method, device and system are very minimally impacted by magnitude of fault resistance. They provide much better fault resistance coverage when compared to existing and proposed distance protection methods, devices and systems.

The present disclosure additionally provides accurate fault location.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any one of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

List of references

[1] https://www.statista.com/statistics/1219587/india-share-of-transmission-line-length-by-voltage/
[2] Z. Q. Bo, X. Z. Dong, B. R. J. Caunce and R. Millar, "Adaptive noncommunication protection of double-circuit line systems," in IEEE Transactions on Power Delivery, vol. 18, no. 1, pp. 43-49, Jan. 2003
[3] A. Hooshyar, M. A. Azzouz and E. F. EI-Saadany, "Distance Protection of Lines Emanating From Full-Scale Converter-Interfaced Renewable Energy Power Plants-Part I: Problem Statement," in IEEE Transactions on Power Delivery, vol. 30, no. 4, pp. 1770-1780, Aug. 2015
[4] Y. Liang, Z. Lu, W. Li, W. Zha and Y. Huo, "A novel fault impedance calculation method for distance protection against fault resistance", IEEE Trans. Power Del., vol. 35, no. 1, pp. 396-407, Feb. 2020
[5] J. Ma, W. Ma, Y. Qiu and J. S. Thorp, "An adaptive distance protection scheme based on the voltage drop equation", IEEE Trans. Power Del., vol. 30, no. 4, pp. 1931-1940, Aug. 2015
[6] A. Hooshyar, M. A. Azzouz and E. F. EI-Saadany, "Distance protection of lines connected to induction generator-based wind farms during balanced faults", IEEE Trans. Sustain. Energy, vol. 5, no. 4, pp. 1193-1203, Oct. 2014
[7] A. Hooshyar, M. A. Azzouz and E. F. EI-Saadany, "Distance protection of lines emanating from full-scale converter-interfaced renewable energy power plants-Part II: Solution description and evaluation", IEEE Trans. Power Del., vol. 30, no. 4, pp. 1781-1791, Aug. 2015
[8] A. Banaiemoqadam, A. Hooshyar and M. A. Azzouz, "A control-based solution for distance protection of lines connected to converter-interfaced sources during asymmetrical faults", IEEE Trans. Power Del., vol. 35, no. 3, pp. 1455-1466, Jun. 2020.
[9] S. Paladhi and A. K. Pradhan, "Adaptive distance protection for lines connecting converter-interfaced renewable plants", IEEEJ. Emerg. Sel. Topics Power Electron., vol. 9, no. 6, pp. 7088-7098, Dec. 2021
[10] N. George, O. D. Naidu and A. K. Pradhan, "Distance Protection for Lines Connecting Converter Interfaced Renewable Power Plants: Adaptive to Grid-end Structural Changes," in IEEE Transactions on Power Delivery, vol. 38, no. 3, pp. 2011-2021, June 2023
[11] Application manual, Line distance protection REL 670.2" [Online]. Available:https://library.e.abb.com/public/8c1eb95cc50243c4c1257d9300423926/1MRK506 338-UUS_-_en_Application_manual__Line_distance_protection_REL670_2.0_ANSI.pdf
[12]L. Kukkala, O. D. Naidu, A. V and S. Sharma, "Single Ended Fault Locator for Power Transmission Lines Connected with Inverter Based Resources: Problems and Mitigation Approach," 2022 22nd National Power Systems Conference (NPSC), New Delhi, India, 2022, pp. 685-690
[13]P. Adhikari, S. Brahma and P. H. Gadde, "Source-Agnostic Time-Domain Distance Relay," in IEEE Transactions on Power Delivery, vol. 37, no. 5, pp. 3620-3629, Oct. 2022.
[14]S. Paladhi, J. R. Kurre and A. K. Pradhan, "Source-Independent Zone-1 Protection for Converter-Dominated Power Networks," in IEEE Transactions on Power Delivery, 2022.

**Claims**

**1.** Method for determining a fault in a double-circuit line (2) comprising a first line (L1) and a second line (L2), the method comprising:

calculating (M1) a first angle of a power at a beginning of a monitored line length of the first line (L1),
calculating (M2) a second angle of a power at an end of the monitored line length of the first line (L1),
performing (M3) an operation with the first angle and the second angle to calculate a first fault factor, and
determining (M4) whether the fault is on the first or second line (L1, L2) based on a polarity of the first fault factor.

**2.** Method according to claim 1, wherein the operation is a multiplication, and
wherein the fault is determined to be on the first line (L1) in case the first fault factor is of a first polarity, and the fault is determined to be on the second line (L2) in case the sign of the first fault factor is of a second polarity.

**3.** Method according to claim 1 or 2, wherein the polarity comprises a sign of the first fault factor, and preferably

wherein the fault is determined to be on the first line (L1) in case the sign of the first fault factor is negative, and the fault is determined to be on the second line (L2) in case the sign of the first fault factor is positive.

4. Method according to any one of claims 1 to 3, further comprising acquiring local voltage and current measurements of the first and second line (L1, L2),
wherein the calculation of the first angle and the second angle are performed using the local voltage and current measurements of the first and second line (L1, L2).

5. Method according to any one of claims 1 to 4, further comprising calculating a fault angle over the complete monitored line length of the line having the fault,
wherein the location of the fault is determined based on a zero crossing of the fault angle.

6. Method according to any one of claims 1 to 5, further comprising acquiring local voltage and current measurements of the first and second line (L1, L2),

calculating a first bus voltage at the end of the monitored line length of the first line (L1) based on the local voltage and current measurements of the first line (L1),
calculating a second bus voltage at an end of a monitored line length of the second line (L2) based on the local voltage and current measurements of the second line (L2), and
determining whether the fault is inside or outside of the monitored line length based on the first and second bus voltage.

7. Method according to claim 6, wherein the fault is determined to be outside of the monitored line length in case a difference between a norm of the first bus voltage and a norm of the second bus voltage is equal or less than a predetermined threshold and the fault is determined to be inside of the monitored line length in case a difference between a norm of the first bus voltage and a norm of the second bus voltage is higher than the predetermined threshold.

8. Method according to any one of claims 1 to 7, wherein the monitored line length of the first line (L1) and the second line (L2) are equal.

9. Method according to any one of claims 1 to 8, further comprising:

calculating a third angle of a power at a beginning of a monitored line length of the second line (L2),
calculating a fourth angle of a power at an end of the monitored line length of the second line (L2),
multiplying the third angle and the fourth angle to calculate a second fault factor, and
determining whether the fault is on the first or second line (L1, L2) based on the sign of the second fault factor.

10. Method according to claim 9, wherein the fault is determined to be on the second line (L2) in case the second fault factor is negative and the fault is determined to be on the first line (L1) in case the second fault factor is positive.

11. Method according to claim 9 or 10, wherein the method further comprises acquiring local voltage and current measurements of the first and second line (L1, L2),
wherein the calculation of the third angle and the fourth angle are performed using the local voltage and current measurements of the first and second line (L1, L2).

12. Method according to any one of claims 1 to 11, wherein the power is calculated as a sum of a positive sequence power, a negative sequence power and a zero sequence power of the first and/or the second line (L1, L2).

13. Device (1) for determining a fault in a double-circuit line (2) comprising a first line (L1) and a second line (L2), wherein the device (1) is connected to the first line (L1) and the second line (L2) and comprises a processor (10) configured to:

calculate a first angle of a power at a beginning of a monitored line length of the first line (L1),
calculate a second angle of a power at an end of the monitored line length of the first line (L1),
performing an operation with the first angle and the second angle to calculate a first fault factor, and
determine whether the fault is on the first or second line (L1, L2) based on the first fault factor.

14. Device (1) according to claim 13, wherein the processor (10) is further configured to perform the method of any one of claims 2 to 12.

15. System for determining a fault in a double-circuit line (2) comprising:

    a first line (L1) and a second line (L2),
    the device (1) according to claim 13 or 14.

**Fig. 1A**

**Fig. 1B**

**Fig. 2**

S1 Acquire local voltage and current measurements from line 1 and/or 2

S2 Perform protection algorithm

S3 Fault line and fault zone identification, determination of fault location, trip decision

**Fig. 3**

Terminal P $I_{PL1}$ Line 1 L1 Terminal Q

$x$ $(1-x)$

$V_P$ R $I_{PL2}$ F $R_F$ Line 2 L2

**Fig. 4**

**Fig. 5A**

**Fig. 5B**

**Fig. 6**

**Fig. 7**

**Fig. 8**

**Fig. 9**

M1 calculating a first angle of a power at a beginning of a monitored line length of the first line

M2 calculating a second angle of a power at an end of the monitored line length of the first line

M3 multiplying the first angle and the second angle to calculate a first fault factor

M4 determining whether the fault is on the first or second line based on a polarity of the first fault factor

**Fig. 10**

1

10

2

L1    L2

**Fig. 11**

Europäisches
Patentamt

European
Patent Office

Office européen
des brevets

**EUROPEAN SEARCH REPORT**

Application Number

EP 23 20 4584

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CN 104 466 947 B (CHINA SOUTHERN POWER GRID CO) 25 August 2017 (2017-08-25) * the whole document * | 1-15 | INV. H02H3/42 G01R31/08 H02H7/26 |
| A | US 2006/097728 A1 (SAHA MURARI M [SE] ET AL) 11 May 2006 (2006-05-11) * the whole document * | 1-15 | |
| A | DINA MOURAD ET AL: "Ultra-High-Speed Non-Unit Protection and Fault Location for Parallel Transmission Lines Earth Faults", IEEJ TRANSACTIONS ON ELECTRICAL AND ELECTRONIC ENGINEERING, JOHN WILEY & SONS, INC, US, vol. 14, no. 10, 28 July 2019 (2019-07-28) , pages 1463-1470, XP072432976, ISSN: 1931-4973, DOI: 10.1002/TEE.22964 * the whole document * | 1-15 | |
| A | DUTTA PAPIYA ET AL: "Transmission-Line Fault Analysis Using Synchronized Sampling", IEEE TRANSACTIONS ON POWER DELIVERY, IEEE SERVICE CENTER, NEW YORK, NY, US, vol. 29, no. 2, 1 April 2014 (2014-04-01), pages 942-950, XP011543732, ISSN: 0885-8977, DOI: 10.1109/TPWRD.2013.2296788 [retrieved on 2014-03-20] * the whole document * | 1-15 | TECHNICAL FIELDS SEARCHED (IPC) H02H G01R |

The present search report has been drawn up for all claims

| Place of search | Date of completion of the search | Examiner |
|---|---|---|
| Munich | 8 April 2024 | Trifonov, Antoniy |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

**EP 23 20 4584**

This annex lists the patent family members relating to the patent documents cited in the above-mentioned European search report.
The members are as contained in the European Patent Office EDP file on
The European Patent Office is in no way liable for these particulars which are merely given for the purpose of information.

**08-04-2024**

| Patent document cited in search report | | | Publication date | Patent family member(s) | | Publication date |
|---|---|---|---|---|---|---|
| CN 104466947 | B | | 25-08-2017 | NONE | | |
| US 2006097728 | A1 | | 11-05-2006 | AT | E377765 T1 | 15-11-2007 |
| | | | | AU | 2003243099 A1 | 06-01-2004 |
| | | | | CA | 2489178 A1 | 31-12-2003 |
| | | | | CN | 1675559 A | 28-09-2005 |
| | | | | DE | 60317344 T2 | 28-08-2008 |
| | | | | EP | 1535081 A1 | 01-06-2005 |
| | | | | ES | 2295641 T3 | 16-04-2008 |
| | | | | JP | 2006505768 A | 16-02-2006 |
| | | | | SE | 525185 C2 | 21-12-2004 |
| | | | | US | 2006097728 A1 | 11-05-2006 |
| | | | | WO | 2004001431 A1 | 31-12-2003 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Z. Q. BO ; X. Z. DONG ; B. R. J. CAUNCE ; R. MILLAR**. Adaptive noncommunication protection of double-circuit line systems. *IEEE Transactions on Power Delivery*, January 2003, vol. 18 (1), 43-49
- **A. HOOSHYAR ; M. A. AZZOUZ ; E. F. EI-SAADANY**. Distance Protection of Lines Emanating From Full-Scale Converter-Interfaced Renewable Energy Power Plants-Part I: Problem Statement. *IEEE Transactions on Power Delivery*, August 2015, vol. 30 (4), 1770-1780
- **Y. LIANG ; Z. LU ; W. LI ; W. ZHA ; Y. HUO**. A novel fault impedance calculation method for distance protection against fault resistance. *IEEE Trans. Power Del.*, February 2020, vol. 35 (1), 396-407
- **J. MA ; W. MA ; Y. QIU ; J. S. THORP**. An adaptive distance protection scheme based on the voltage drop equation. *IEEE Trans. Power Del.*, August 2015, vol. 30 (4), 1931-1940
- **A. HOOSHYAR ; M. A. AZZOUZ ; E. F. EI-SAADANY**. Distance protection of lines connected to induction generator-based wind farms during balanced faults. *IEEE Trans. Sustain. Energy*, October 2014, vol. 5 (4), 1193-1203
- **A. HOOSHYAR ; M. A. AZZOUZ ; E. F. EI-SAADANY**. Distance protection of lines emanating from full-scale converter-interfaced renewable energy power plants-Part II: Solution description and evaluation. *IEEE Trans. Power Del.*, August 2015, vol. 30 (4), 1781-1791

- **A. BANAIEMOQADAM ; A. HOOSHYAR ; M. A. AZZOUZ**. A control-based solution for distance protection of lines connected to converter-interfaced sources during asymmetrical faults. *IEEE Trans. Power Del.*, June 2020, vol. 35 (3), 1455-1466
- **S. PALADHI ; A. K. PRADHAN**. Adaptive distance protection for lines connecting converter-interfaced renewable plants. *IEEEJ. Emerg. Sel. Topics Power Electron.*, December 2021, vol. 9 (6), 7088-7098
- **N. GEORGE ; O. D. NAIDU ; A. K. PRADHAN**. Distance Protection for Lines Connecting Converter Interfaced Renewable Power Plants: Adaptive to Grid-end Structural Changes. *IEEE Transactions on Power Delivery*, June 2023, vol. 38 (3), 2011-2021
- Application manual, Line distance protection REL 670.2
- **L. KUKKALA ; O. D. NAIDU, A. V ; S. SHARMA**. Single Ended Fault Locator for Power Transmission Lines Connected with Inverter Based Resources: Problems and Mitigation Approach. *2022 22nd National Power Systems Conference (NPSC), New Delhi, India*, 2022, 685-690
- **P. ADHIKARI ; S. BRAHMA ; P. H. GADDE**. Source-Agnostic Time-Domain Distance Relay. *IEEE Transactions on Power Delivery*, October 2022, vol. 37 (5), 3620-3629
- **S. PALADHI ; J. R. KURRE ; A. K. PRADHAN**. Source-Independent Zone-1 Protection for Converter-Dominated Power Networks. *IEEE Transactions on Power Delivery*, 2022